# FASCICULE DE BREVET EUROPEEN

(11) **EP 2 605 274 B1**
(45) Date de publication et mention de la délivrance du brevet: **18.02.2015**
(21) Numéro de dépôt: 12196002.5
(22) Date de dépôt: 07.12.2012
(51) Int. Cl.: H01L 23/34, H01L 23/367, F25D 19/00, F28F 13/00, H05K 7/20

(54) **DISPOSITIF ÉLECTRONIQUE**
ELEKTRONISCHES BAUELEMENT
ELECTRONIC COMPONENT

(30) Priorité: 13.12.2011 FR 1161530
(43) Date de publication de la demande: 19.06.2013
(73) Titulaire: Commissariat à l'Énergie Atomique et aux Énergies Alternatives, 75015 Paris (FR)
(72) Inventeur: Ben Jamaa, Haykel, 38000 GRENOBLE (FR); Buckley, Julien, 38000 GRENOBLE (FR); Leduc, Patrick, 38000 GRENOBLE (FR)
(74) Mandataire: Colombo, Michel

(56) Documents cités:
- US-A- 4 402 358
- US-A- 4 742 867
- US-A- 5 867 990
- US-A1- 2006 066 434
- US-A1- 2009 040 007
- US-B1- 6 301 114

## Description

L'invention concerne un dispositif électronique ainsi qu'une plaque pour ce dispositif électronique.

Les performances d'un dispositif électronique dépendent souvent de la capacité à le refroidir efficacement. A cet effet, des dispositifs électroniques connus comportent :
- au moins une source de chaleur générant de la chaleur,
- au moins un point froid apte à absorber de la chaleur,
- un matériau thermiquement isolant, dont la conductivité thermique à la température d'utilisation T_{f} du dispositif est inférieure à un seuil S₁, ce matériau isolant thermiquement la source de chaleur du point froid, et
- au moins un pont thermique s'étendant entre au moins deux extrémités raccordées thermiquement, respectivement, à la source de chaleur et au point froid.

On entend par température d'utilisation, la température moyenne de l'environnement dans lequel le dispositif électronique fonctionne.

Dans ces dispositifs électroniques connus, le pont thermique est typiquement au moins une piste en métal ou en matériau semi-conducteur qui s'étend continûment d'une extrémité vers l'autre. De tels ponts thermiques permettent de diriger le flux de chaleur de la source de chaleur vers le point froid et donc d'améliorer le refroidissement du dispositif électronique. Dans plusieurs dispositifs électroniques connus, le pont thermique est inexistant ou peu efficace.

La source de chaleur peut être un module électronique quelconque dissipant de la chaleur, par exemple des résistances ou des oscillateurs à base de capacité et d'inductance. Toutefois, souvent, la source de chaleur est un module électronique réalisé à base de transistors. Dans les dispositifs électroniques connus, notamment les dispositifs électroniques nomades, l'activité d'un module électronique peut fortement varier. Par exemple, un module électronique peut passer d'un état inactif dans lequel il n'est pas alimenté ou peu utilisé vers un état actif dans lequel il est très fortement utilisé. Dans l'état inactif, il ne produit pas ou relativement peu de chaleur. A l'inverse, dans l'état actif, il peut produire beaucoup de chaleur, ce qui peut provoquer une forte augmentation de sa température.

Ainsi, dans de tels dispositifs électroniques, la source de chaleur n'est pas toujours au même endroit. De plus, selon l'activité du dispositif électronique, le module électronique à refroidir en priorité n'est pas toujours le même.

Les ponts thermiques connus ne permettent pas de répondre de façon satisfaisante à ces changements de condition de fonctionnement du dispositif électronique. Dans ce contexte, ils sont donc peu efficace pour répartir correctement la chaleur dans le dispositif électronique.

De l'état de la technique est également connu de :
- US2009/040007 A1,
- US5 867 990 A,
- US6 301 114 B1,
- US4 402 358 A,
- US2006/066434 A1,
- US4 742 867 A.

L'invention vise à remédier à cet inconvénient. Elle a donc pour objet un dispositif électronique conforme à la revendication 1.

Grâce à la présence d'un interrupteur thermique dans le pont thermique, celui-ci peut être reconfiguré de façon automatique pour s'adapter au mieux à l'activité et à l'état de fonctionnement du dispositif électronique. Ainsi, les flux de chaleur dans le dispositif électronique peuvent être contrôlés et optimisés, ce qui permet, enfin de compte, d'augmenter les performances de ce dispositif électronique.

Les modes de réalisation de ce dispositif électronique peuvent comporter une ou plusieurs des caractéristiques des revendications dépendantes.

Ces modes de réalisation du dispositif électronique présentent en outre les avantages suivants :
l'utilisation d'un matériau à conductivité thermique variable permet d'éviter le recours à des parties mobiles se déplaçant mécaniquement pour basculer entre les états conducteur et résistif ;
- l'utilisation d'un électrolyte solide pour réaliser le matériau à conductivité thermique variable permet de faciliter la fabrication du dispositif électronique car de tels matériaux sont simples à incorporer dans un dispositif électronique en utilisant les procédés classiques de fabrication de la microélectronique.
- l'utilisation d'interrupteurs thermiques dont le changement de la conductivité thermique peut être non volatile permet de ne pas nécessiter un apport d'énergie continu pour rester dans un état prédéfini.

L'invention a également pour objet une plaque pour le dispositif électronique ci-dessus conforme à la revendication 11.

Les modes de réalisation de cette plaque peuvent comporter une ou plusieurs des caractéristiques des revendications dépendantes de plaque.

Ces modes de réalisation de la plaque présentent en outre les avantages suivants :
- le fait d'avoir une piste enfouie à l'intérieur de substrat raccordée aux plots d'extrémité par l'intermédiaire d'interrupteurs thermiques permet de contrôler efficacement l'écoulement du flux de chaleur entre différents points de la face de contact ;
- l'utilisation d'un interrupteur thermique pour raccorder thermiquement et, en alternance, isoler thermiquement des pistes thermiquement conductrices permet une plus grande flexibilité dans la manière de répartir la chaleur entre différents plots de la face de contact.

L'invention sera mieux comprise à la lecture de la description qui va suivre, donnée uniquement à titre d'exemple non limitatif et faite en référence aux dessins sur lesquels :
- la figure 1 est une illustration schématique en coupe verticale d'un dispositif électronique équipé d'une plaque pour son refroidissement;
- la figure 2 est une illustration schématique et partielle d'une grille thermiquement conductrice utilisée dans la plaque de la figure 1 pour refroidir des modules électroniques ;
- la figure 3 est un organigramme d'un procédé de fonctionnement du dispositif électronique de la figure 1 ;
- la figure 4 est un organigramme d'un procédé de fabrication du dispositif électronique de la figure 1 ; - les figures 5 à 8 sont des illustrations schématiques de différentes étapes de fabrication du procédé de la figure 4 ;
- la figure 9 est une illustration schématique et en coupe verticale d'un autre mode de réalisation de la plaque de la figure 1 ;
- la figure 10 est un organigramme d'un procédé de fabrication de la plaque de la figure 9 ;
- les figures 11 à 13 sont des illustrations schématiques de différentes étapes du procédé de la figure 10 ;
- la figure 14 est une illustration schématique et en coupe verticale d'un autre mode de réalisation de la plaque de la figure 1 ;
- la figure 15 est un organigramme d'un procédé de fabrication de la plaque de la figure 14 ;
- les figures 16 et 17 sont des illustrations schématiques et en coupe verticale de différentes étapes de fabrication du procédé de la figure 15 ;
- la figure 18 est une illustration schématique et en coupe verticale d'un autre mode de réalisation de la plaque du dispositif électronique de la figure 1 ;
- les figures 19 à 21 sont des illustrations schématiques et en coupe verticale partielles de différentes autres variantes de réalisation de la plaque du dispositif électronique de la figure 1 ;
- les figures 22 et 23 sont des organigrammes de variantes du procédé de fonctionnement de la figure 3.

Dans la suite de la description, les mêmes éléments portent les mêmes références numériques sur les figures. Les dispositifs et fonctions bien connus de l'homme du métier ne sont pas été décrits ici en détail.

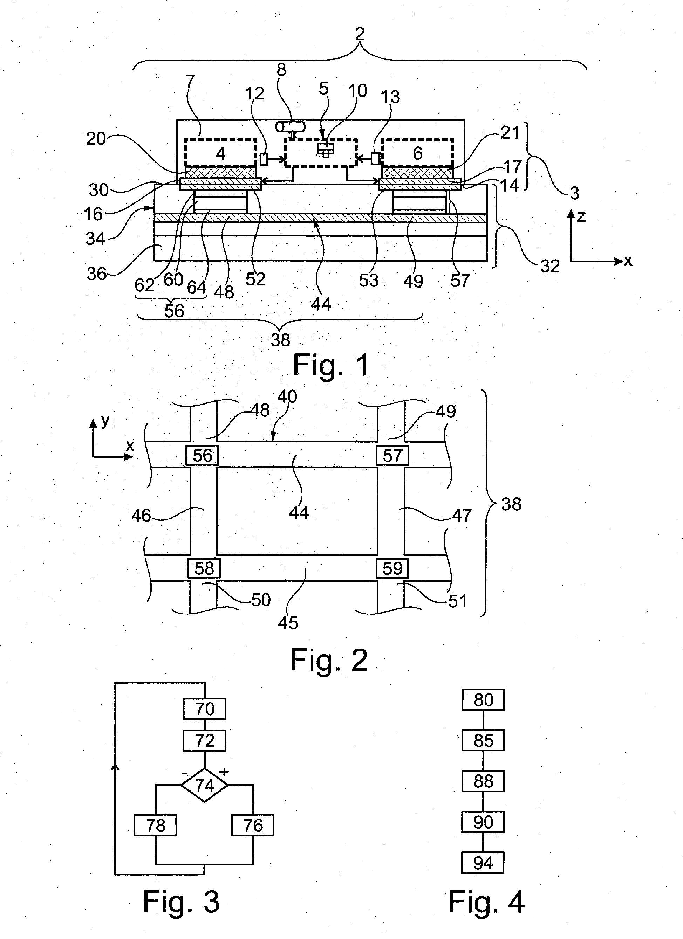

La figure 1 représente un dispositif électronique 2. Ce dispositif 2 comporte un circuit intégré 3. Ici, ce circuit intégré 3 est un circuit intégré de type 2D. Un tel circuit intégré est formé par des composants électroniques dissipant de la chaleur disposés dans un même plan inférieur qui s'étend horizontalement. Le plan horizontal est parallèle à deux directions orthogonales X et Y. La direction verticale est représentée par la direction Z perpendiculaire aux directions X et Y. Le circuit intégré 2 peut éventuellement comporter des composants électroniques disposés dans plusieurs plans supérieurs situés au-dessus du plan inférieur dans la direction verticale. Dans ce dernier cas, il s'agit alors d'un circuit intégré de type 3D. Les composants électroniques du plan supérieur sont raccordés électriquement aux composants électroniques du plan inférieur par l'intermédiaire de connexion électrique verticale plus connue sous le terme de « via ».

Les composants électroniques dissipant de la chaleur sont typiquement des composants électroniques capables de changer d'état en réponse à une commande. Lors de chaque changement d'état, une partie de l'énergie apportée aux composants électroniques est dissipée sous forme de chaleur. Typiquement, les composants électroniques sont des transistors. Ces composants électroniques sont regroupés localement et interconnectés entre eux pour former des modules électroniques qui remplissent des fonctions prédéterminées telles que, par exemple, celles d'un microprocesseur ou coprocesseur électronique, ou de modules de télécommunication. Les modules électroniques sont isolés thermiquement les uns des autres par l'intermédiaire d'un matériau thermiquement isolant 7.

Dans la suite de cette description, lorsqu'un tel module électronique fonctionne, on dit qu'il est actif. Un module électronique actif transforme donc une partie de l'énergie qu'il reçoit sous forme d'électricité en chaleur, principalement à cause de la commutation des différents transistors qui le composent entre leurs états passant et non passant. Ainsi, chaque module électronique actif constitue une source de chaleur.

A l'inverse, lorsqu'un module électronique ne fonctionne pas, on dit qu'il est inactif. Chaque module électronique inactif peut absorber de la chaleur au lieu d'en produire. En effet, un module inactif n'est pas alimenté. Dans ce cas, ils peuvent remplir la fonction de point froid.

Pour simplifier la figure 1, seuls trois modules électroniques 4 à 6 du circuit intégré 3 ont été représentés. Par exemple, le module électronique 5 est un calculateur électronique programmable apte à exécuter des instructions enregistrées sur un support d'enregistrement d'informations. A cet effet, il est raccordé à une mémoire 8. A titre d'illustration, la mémoire 8 est logée à l'intérieur du circuit intégré 3. La mémoire 8 contient les instructions nécessaires pour exécuter le procédé de la figure 3. En particulier, le module 5 implémente un module programmable 10 de commande.

Le circuit intégré 3 comprend une face inférieure 14 en matériau thermiquement isolant et électriquement isolant. La face 14 peut être la face supérieure du circuit intégré durant la phase de fabrication, qui devient sa face inférieure quand il est retourné pendant le collage des circuits suivant la procédure connue sous le terme anglais de « flip chip ». Des plots réalisés dans un matériau thermiquement conducteur et électriquement conducteur affleurent sur cette face 14. Ici, un matériau est dit « thermiquement conducteur » si sa conductivité thermique à la température T_{f} d'utilisation du dispositif 2 est au moins 3 fois et de préférence 100 ou 300 fois supérieure à la conductivité thermique à la température T_{f} du matériau thermiquement isolant. Dans la suite de cette description, toutes les valeurs de conductivité thermique sont données pour la température T_{f}. Ici, la température T_{f} est prise égale à 20°C. Typiquement, la conductivité thermique à la température T_{f} d'un matériau thermiquement conducteur est supérieure à 150 ou 300 W/K/m. A l'inverse, la conductivité thermique d'un matériau thermiquement isolant à la température T_{f} est strictement inférieure à 150W/K/m (ce qui correspond à une conductivité thermique moyenne) et, de préférence, inférieure à 20, 10 ou 1 W/K/m.

On considère qu'un matériau est électriquement conducteur si sa résistivité à la température T_{f} est inférieure à 10⁻² ou 10⁻⁵ Ω.m. A l'inverse, un matériau électriquement isolant a typiquement une résistivité électrique à la température T_{f} supérieure à 10² ou 10³ Ω.m.

Par exemple, le matériau thermiquement isolant est du Si02 ou un polymère. Ici, le matériau thermiquement isolant est du SiO₂.

Par exemple, le matériau thermiquement conducteur est du cuivre, de l'argent, du tungstène, du graphène ou du diamant. Dans la suite de cette description, on suppose que le matériau thermiquement conducteur est du cuivre à moins qu'il en soit indiqué autrement.

Pour simplifier la figure 1, seuls deux plots 16, 17 affleurant sur la face inférieure 14 ont été représentés. Chaque plot 16, 17 est thermiquement raccordé à un module électronique respectif. Ici, les plots 16 et 17 sont thermiquement raccordés, respectivement, aux modules électroniques 4 et 6. Pour cela, par exemple, chaque plot 16, 17 est raccordé à un motif, respectivement 20, 21, en contact thermique avec le module électronique. Les motifs 20 et 21 sont une zone de séparation entre les modules électroniques 4 et 6 et les plots 16 et 17. Les motifs 20 et 21 forment chacun un passage préférentiel pour le flux de chaleur circulant, respectivement, entre les plots 16, 17 et les modules 4, 6. A cet effet, leur conductivité thermique est de préférence proche ou égale ou supérieure à celle des matériaux thermiquement conducteur. Ils peuvent être formés d'une fine couche réalisée dans un matériau électriquement isolant ou conducteur ou semi-conducteur, ou d'un ensemble de deux ou plusieurs matériaux parmi ces matériaux. Par « fine » couche, on désigne les couches dont l'épaisseur est inférieure à 10 µ et, typiquement, inférieure à 1 µm ou 500 nm. L'épaisseur de ces couches est donc suffisamment fine pour considérer que le contact thermique est établi quelle que soit la nature du matériau utilisé pour réaliser cette couche fine. Ces couches ou motifs peuvent être structurées, et contenir, par exemple, des vias ou des lignes en matériau thermiquement conducteur tel qu'un métal. La présence des vias n'est cependant pas indispensable.

Les plots 16, 17 sont électriquement raccordés au module 5 pour que le module 10 de commande puisse leur appliquer une tension.

Le circuit intégré 2 comporte un réseau de capteurs de température apte chacun à mesurer la température d'un module électronique respectif. Typiquement, chaque capteur est placé à proximité du module électronique dont il doit mesurer la température. Ainsi, chaque capteur est plus sensible à la température du module électronique qui se trouve à proximité qu'à la température des autres modules électroniques. Chaque capteur est raccordé au module électronique 5 pour communiquer la température mesurée au module 10 de commande. Pour simplifier la figure 1, seuls deux capteurs 12 et 13 de température sont représentés, respectivement, à proximité des modules 4 et 6.

La face inférieure 14 du circuit intégré 2 est collée sur une face supérieure 30 d'une plaque 32. La face supérieure 30 est la face d'un bloc 34 en matériau thermiquement et électriquement isolant. Le bloc 34 est une seule couche ou plusieurs couches en matériau thermiquement isolant empilées les unes au-dessus des autres. Ce bloc 34 s'étend essentiellement dans un plan horizontal. Ici, ce bloc 34 est disposé sur un substrat 36 en silicium.

La plaque 32 comprend au moins un pont thermique 38. Le pont thermique 38 comprend :
- une grille 40 en matériau thermiquement conducteur,
- des plots d'extrémité en matériau thermiquement conducteur et électriquement conducteur affleurant sur la face supérieure 30,
- des interrupteurs thermiques interposés entre chaque plot d'extrémité et la grille 40.

La grille 40 s'étend continûment dans un plan horizontal. Cette grille 40 est enfouie à l'intérieur du bloc 34.

La figure 2 représente plus en détail cette grille 40. Elle comprend plusieurs pistes en matériau thermiquement conducteur s'étendant parallèlement à la direction X et d'autres pistes en matériau thermiquement conducteur s'étendant parallèlement à la direction Y. Les pistes parallèles à la direction X sont identiques entre elles. De même, les pistes parallèles à la direction Y sont identiques entre elles et identiques aux pistes parallèles à la direction X à l'exception de leur direction. Pour simplifier la figure 2, seules deux pistes 44 et 45 parallèles à la direction X et seules pistes 46 et 47 parallèles à la direction Y ont été représentées.

Chaque intersection entre une piste parallèle à la direction X et une piste parallèle à la direction Y est constituée d'une partie de piste commune à ces deux pistes. Sur la figure 2, les intersections entre la piste 44 et les pistes 46 et 47 portent les références, respectivement, 48 et 49 et les intersections entre la piste 45 et les pistes 46 et 47 portent les références, respectivement, 50 et 51.

La grille 40 est raccordée en permanence à un potentiel de référence tel que la masse.

Un plot d'extrémité est situé au-dessus et à la verticale de chaque intersection de la grille 40. Sur la figure 1, seuls des plots 52 et 53 en vis-à-vis des intersections 48 et 49 sont représentés. Ces plots 52 et 53 sont directement en contact mécanique avec, respectivement, les plots 16 et 17 du circuit intégré 3.

Sur la figure 1, seuls des interrupteurs thermiques 56 et 57 interposés, respectivement, entre l'intersection 48 et le plot 52 et entre l'intersection 49 et le plot 53 sont représentés. Sur la figure 2, les interrupteurs thermiques disposés au-dessus des intersections 50 et 51 portent, respectivement, les références 58 et 59. Ici, tous les interrupteurs thermiques sont identiques et seul l'interrupteur 56 va maintenant être décrit en détail.

L'interrupteur 56 est apte à basculer de façon réversible, en réponse à une commande du module 10, entre :
- un état conducteur dans lequel la valeur λ_{c} de sa conductivité thermique est supérieure à la valeur λᵢ du bloc 34,
- un état résistif dans lequel la valeur λᵣ de sa conductivité thermique est inférieure à la valeur λ_{c}.

De préférence, la valeur λᵣ est inférieure ou égale à la valeur λᵢ.

Typiquement, le ratio λ_{c}/λᵣ est supérieur à 2 ou 2,5, de préférence supérieur à 5 ou 10 dans des conditions normales de commande de cet interrupteur.

Dans ce mode de réalisation, l'interrupteur thermique 56 est réalisé à partir d'un matériau à conductivité thermique variable. Ce matériau est ici un électrolyte solide 60.

L'électrolyte 60 est directement en contact mécanique, du côté supérieur, avec une électrode soluble 62 et du côté inférieur, avec une électrode inerte 64.

L'électrolyte 60 est capable de basculer entre une phase conductrice dans laquelle la valeur de sa conductivité thermique est égale à λ_{c} et une phase résistive dans laquelle la valeur de sa conductivité thermique est égale à λᵣ.

La conductivité thermique de l'interrupteur 56 passe de la valeur λᵣ à la valeur λ_{c} en réponse à l'application d'une différence de potentiels entre ses électrodes 62 et 64. En effet, en présence d'une différence de potentiels entre ses électrodes, l'électrode 62 se dissout dans l'électrolyte 60, ce qui augmente la conductivité thermique de l'électrolyte 60.

De plus, dans un tel mode de réalisation, la conductivité thermique de l'électrolyte 60 reste égale à λ_{c} même après la disparition de la différence de potentiels. Pour ramener la conductivité thermique de l'interrupteur 56 à sa valeur λᵣ, il faut appliquer une différence de potentiels de signe opposé.

Ici, l'interrupteur 56 est réalisé comme une cellule d'une mémoire CBRAM (Conductive Bridging Random Access Memory) ou PMC (Programable Metallization Cell) ou OxRAM (Resistive Random Access Memory), ou d'une manière générale, RRAM (Resistive Random Access Memory). Pour la réalisation de l'interrupteur 56, on peut donc se référer à des documents relatifs à la fabrication de ces cellules de mémoire. Par exemple, l'article suivant décrit différentes réalisations de ces cellules de mémoire:
An Chen, « lonic memories : Status and challenges », 978-1-4244-24115, IEEE 2008.

Par exemple, l'électrolyte 60 est composé à plus de 90 % ou 98 % d'un élément ou d'éléments choisis dans le groupe suivant :
- sulfites de métaux tels que Cu₂S, Ag₂S,
- chalcogénides à base de germanium tels que GeSe,
- oxydes de métaux tels que Ta₂O₅, WO₃, SiO₂, TiO₂,
- ZnCdS, GdOₓ/Cu-Te.

L'électrode 62 est réalisée dans un matériau ayant un potentiel redox lui permettant de s'ioniser et un coefficient de diffusion lui permettant de se dissoudre dans l'électrolyte 60. L'électrode 62 est typiquement choisie dans le groupe composé du cuivre, de l'argent et du zinc.

L'électrode 64 est réalisée dans un matériau qui ne réagit pas avec l'électrolyte 60. Par exemple, il s'agit de l'alliage TiN.

Le fonctionnement du dispositif 2 va maintenant être décrit en référence à la figure 3. La plaque 32 est commandée de manière à ce que la température d'un module électronique ou d'autres modules électroniques dans le voisinage immédiat de ce module électronique ne s'élève pas trop.

Initialement, l'ensemble des interrupteurs thermiques de la plaque 32 sont dans leur état résistif.

Lors d'une étape 70, les capteurs 12 et 13 mesurent les températures des modules électroniques 4 et 6 du dispositif 2.

Lors d'une étape 72, le module 10 de commande acquiert ces mesures.

Ensuite, lors d'une étape 74, le module 10 détermine, s'il en existe, quels sont les modules électroniques qui doivent être refroidis. Par « refroidir», on désigne ici non seulement le fait d'abaisser la température de ce module mais aussi le fait de limiter ou d'empêcher que la température de ce module n'augmente. Par exemple, le module 10 considère qu'un module électronique doit être refroidi si sa température dépasse un seuil T_{c}.

Lors de l'étape 74, le module 10 détermine aussi quels sont les modules électroniques dont la température est basse, c'est-à-dire dont la température est inférieure à un seuil T_{f} et dont la température peut être augmentée sans risque de l'endommager. Par exemple, il s'agit typiquement de la température d'un module électronique inactif.

S'il existe au moins un module électronique dont la température dépasse le seuil T_{c}, alors le module 10 procède à l'étape 76. Ici, on suppose que c'est le module électronique 4 qui fonctionne et qui doit être refroidi tandis que le module 6 est inactif et peut donc servir de point froid.

Lors de l'étape 76, le module 10 commande les interrupteurs 56, 57 du pont thermique 38 pour raccorder thermiquement les modules 4 et 6 afin de limiter l'augmentation de la température du module 4. Pour cela, le module 10 fait basculer les interrupteurs 56 et 57 dans leur état conducteur. Plus précisément, lors de l'étape 76, le module 10 applique une impulsion de tension sur les plots 16 et 17 pour créer la différence de potentiels nécessaire au basculement des interrupteurs 56 et 57 de leur état résistif vers leur état conducteur. Typiquement, la durée de l'impulsion est inférieure à 1s ou à 1µs. L'amplitude de l'impulsion de tension est par exemple inférieure à 5 ou 1V.

Lorsque les interrupteurs 56 et 57 sont dans l'état conducteur, la chaleur générée par le module 4 se diffuse vers le module 6 par l'intermédiaire des interrupteurs 56, 57 et de la piste 44. Ainsi, cela limite l'augmentation de la température du module 4 et, à l'inverse, fait augmenter la température du module 6.

Si lors de l'étape 74, la température des modules électroniques 4 et 6 ne dépasse pas ou ne dépasse plus le seuil T_{c}, alors il est procédé à une étape 78. Lors de l'étape 78, le module 10 commande les interrupteurs 56, 57 précédemment basculés dans leur état conducteur pour les basculer dans leur état résistif.

Les étapes 70 à 78 sont réitérées en boucle de manière à optimiser en permanence la répartition des flux de chaleur à l'intérieur du dispositif 2. Ceci permet en particulier, de mieux uniformiser la température intérieure du dispositif 2 et donc, en fin de compte, d'augmenter les performances de ce dispositif et en particulier du circuit intégré 3.

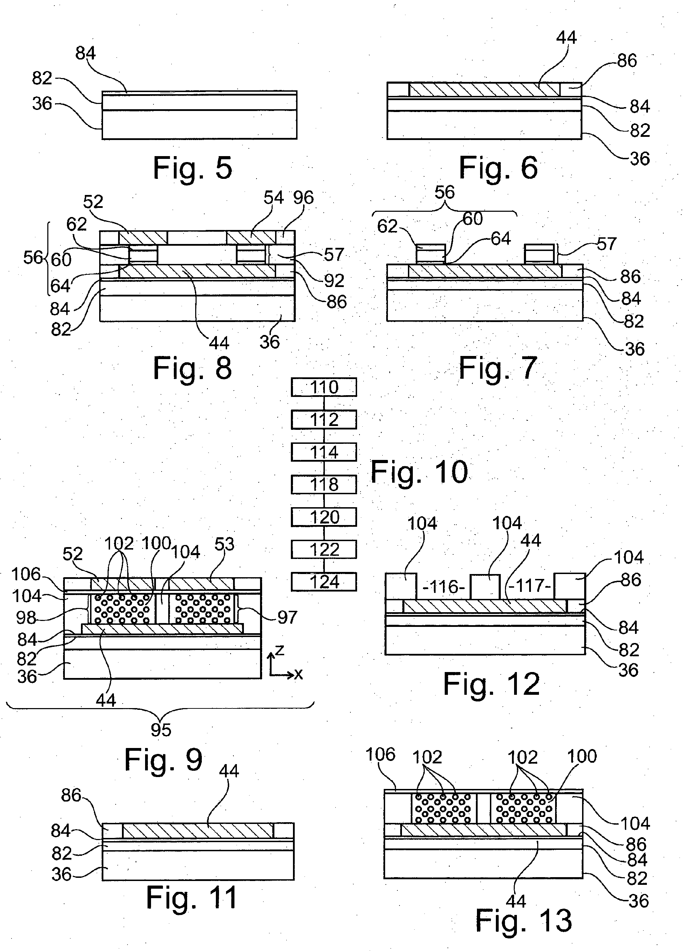

La figure 4 représente un procédé de fabrication de la plaque 32 tandis que les figures 5 à 8 représentent plus en détail différentes étapes de fabrication de cette plaque 32.

Lors d'une étape 80, le substrat 36 sur lequel est déposée une couche 82 en matériau thermiquement isolant et une couche 84 d'arrêt de gravure est produit (figure 5). Par exemple, le matériau thermiquement isolant est du SiO₂.

Lors d'une étape 85, les pistes de la grille 40 sont déposées. Par exemple, ces pistes sont en cuivre et elles sont déposées à l'aide d'un procédé Damascène (figure 6). Sur la figure 6, seule la piste 44 a été représentée. L'épaisseur de la piste 44 est de préférence inférieure à 10 µm ou 1 µm ou 400 nm. Son épaisseur est également de préférence supérieure à 50 nm. Les espaces entre les différentes pistes de la grille 40 sont remplis d'un matériau thermiquement isolant 86.

Lors d'une étape 88, un interrupteur thermique est fabriqué sur chaque intersection des pistes de la grille 40. Pour cela, on procède successivement au dépôt et à la gravure :
- de l'électrode 64,
- de l'électrolyte solide 60, puis
- de l'électrode 62.

Par exemple, ici, l'électrolyte est du SiO₂ tandis que l'électrode 62 est en argent.

Lors d'une étape 90, une couche 92 en matériau thermiquement isolant est déposée puis planarisée pour laisser affleurer l'électrode 62 (figure 8).

Ensuite, lors d'une étape 94, les plots d'extrémité 52 et 53 sont directement définis sur les électrodes 62 (figure 8) suivant le procédé Damascène comme suit : une couche de matériau thermiquement isolant 96 est déposée, et des ouvertures des plots d'extrémité 52 et 53 sont faites dans cet isolant. Ensuite, le matériau des plots d'extrémité 52 et 53, par exemple le cuivre, est déposé pour remplir les ouvertures. Une planarisation de la structure permet ensuite de définir les plots d'extrémité 52 et 53. Les couches 82, 84, 86, 92 et 96 forment le bloc 34.

Le circuit intégré 3 est fabriqué en parallèle des étapes 80 à 94 par des procédés connus de fabrication en microélectronique.

Enfin, lors d'une étape 96, la plaque 32 ainsi réalisée est collée, typiquement par collage moléculaire, sur la face inférieure 14 du circuit intégré 3 de sorte que les plots 16 et 17 sont collés sur les plots correspondants 52 et 53 de la plaque 32.

La figure 9 représente une plaque 95 identique à la plaque 32 sauf que les interrupteurs 56 et 57 sont remplacés par des interrupteurs, respectivement, 97 et 98. Dans ce mode de réalisation, le matériau à conductivité thermique variable est un fluide thermiquement isolant 100 mélangé avec des nanoparticules 102 thermiquement conductrices. Ici, le fluide 100 est un liquide thermiquement isolant tel qu'un électrolyte liquide. Par exemple, il s'agit de l'éthanol.

Les nanoparticules 102 sont des nanoparticules qui s'alignent sur les lignes de champ électrique qui apparaissent lorsqu'une différence de potentiels existe entre les plots 52 et 53 et la piste 44. Lorsque ces nanoparticules s'alignent, elles forment une multitude de ponts thermiques microscopiques entre les plots 52 et 53 et la piste 44, ce qui diminue la conductivité thermique de l'interrupteur.

De préférence, les nanoparticules 102 présentent un grand facteur de forme, c'est-à-dire que le rapport de leur longueur sur leur largeur est typiquement supérieur à 2, 10 ou 100. Par exemple, les nanoparticules 102 sont des nanotubes de carbone ou des fullerènes. L'alignement de ces nanoparticules sur le champ électrique est par exemple décrit dans l'article suivant :
X.Q Chen et T. Saito, H. Yamada, K. Matsushige « Aligning single-wall carbon nanotubes with an alternating-current field », Applied Physics Letters, vol. 78, numéro 23, 4 juin 2001.

Les nanoparticules 102 sont contenus dans des cavités dont le fond est formé par la face supérieure de la piste 44 et la paroi verticale par des murs verticaux 104 en matériau thermiquement isolant. Ici, la cavité dans laquelle est reçu le liquide 100 est refermée par un capot 106 en silicium. De préférence, l'épaisseur de ce capot est faible, c'est-à-dire par exemple, inférieure à 10 µm et, de préférence, inférieure à 400, à 100 ou à 30 nm.

Le fonctionnement de cette plaque 95 lorsqu'elle est associée au circuit intégré 3 est identique à celui précédemment décrit en référence à la figure 3.

Le procédé de fabrication de cette plaque 95 va maintenant être décrit à l'aide du procédé de la figure 10 et des figures 11 à 13.

La fabrication de la plaque 95 débute par des étapes 110 et 112 respectivement identiques aux étapes 80 et 85 de la figure 4. On obtient alors la plaque dans l'état représenté dans la figure 11.

Ensuite, lors d'une étape 114, une couche en matériau thermiquement isolant est déposée puis gravée pour former les murs verticaux 104. Ces murs verticaux 104 définissent des cavités au-dessus de chaque intersection de la grille 40 (figure 12). Sur la figure 12, seules deux cavités 116 et 117 situées respectivement au-dessus des intersections 48 et 49 ont été représentées. Le fond de ces cavités est formé par la piste 44.

Lors d'une étape 118, chacune des cavités est remplie avec le fluide 100 mélangé aux nanoparticules 102.

Ensuite, lors d'une étape 120, le capot 106 est déposé et collé sur le sommet des murs 104 pour refermer chacune des cavités précédemment remplies (figure 13). Le capot peut être aminci davantage après le collage.

Lors d'une étape 122, les plots d'extrémité 52 et 53 sont formés de façon similaire à ce qui a été décrit lors de l'étape 94.

Ensuite, lors d'une étape 124, la plaque 95 est collée, par collage moléculaire, sur la face inférieure 14 du circuit intégré 3.

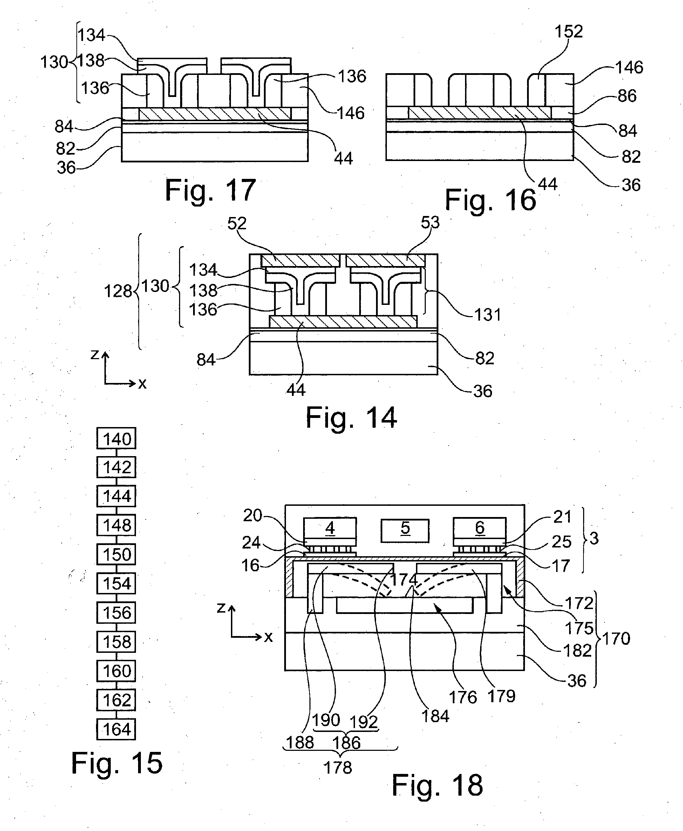

La figure 14 représente une plaque 128 identique à la plaque 32 sauf que les interrupteurs 56 et 57 sont remplacés par des interrupteurs 130 et 131. Ces interrupteurs 130 et 131 sont identiques et seul l'interrupteur 130 va maintenant être décrit en détail. L'interrupteur 130 comprend une électrode soluble 134 et une électrode inerte 136 disposées verticalement pour accroître l'intensité des lignes de champ électrique créées entre ces deux électrodes. Ici, l'électrode 136 forme les flancs verticaux d'une cavité remplie par un électrolyte solide 138. L'électrode 134 forme une tige verticale qui s'étend à l'intérieur de la cavité remplie par l'électrolyte 138 de sorte que cet électrolyte se trouve essentiellement interposée entre cette tige verticale et l'électrode inerte 136 verticale. Ici, l'électrode 134 et l'électrolyte 138 sont réalisées dans les mêmes matériaux que, respectivement, l'électrode 62 et l'électrolyte 60. L'électrode 136 est réalisée en siliciure.

La figure 15 représente un procédé de fabrication de la plaque 128. Ce procédé débute par des étapes 140 et 142 identiques aux étapes 80 et 85 de la figure 4.

Ensuite, lors d'une étape 144, une couche 146 (figure 16) en matériau thermiquement isolant est déposée sur la grille 40.

Lors d'une étape 148, la couche 146 est gravée pour former des cavités au-dessus de chaque intersection des pistes de la grille 40. Le fond de cette cavité est formé par l'intersection des pistes de la grille 40.

Lors d'une étape 150, une couche 152 (figure 16) de silicium amorphe ou polycristallin est déposée sur la couche 146 puis gravée de façon anisotrope pour ne laisser subsister cette couche 152 que sur les parois verticales des cavités creusées. L'épaisseur de cette couche 152 est comprise typiquement entre 10 nm et 800 µm.

Lors d'une étape 154, un film de nickel ou de platine est déposé sur la couche 152. Pour simplifier les figures, ce film n'a pas été représenté.

Lors d'une étape 156, on procède à un recuit de la couche 152 à une température typiquement comprise entre 200 et 400°C pour transformer la couche 152 en la couche 136 de siliciure.

Lors d'une étape 158, une couche formant l'électrolyte 138 et une couche formant l'électrode 134 sont successivement déposées et gravées de manière à obtenir l'électrolyte 138 et l'électrode 134 (figure 17). L'électrode 134 peut être planarisée à ce niveau. Les étapes suivantes 160, 162 et 164 sont respectivement identiques aux étapes 90, 94 et 96 de la figure 4.

La figure 18 représente une autre plaque 170 collée sur la face inférieure 14 du circuit intégré 3 pour diffuser de la chaleur du module électronique 4 vers le module électronique 6 lorsque cela est nécessaire. Plus précisément, la face inférieure 14 est collée sur le toit d'un capot 172 renfermant une cavité 174 remplie d'un fluide thermiquement isolant tel que de l'air. La plaque 170 comprend un pont thermique 175. Ce pont 175 comprend :
- une piste 176 en matériau thermiquement conducteur, et
- deux interrupteurs thermiques 178 et 179.

La piste 176 est enfouie à l'intérieur d'une couche 182 en matériau thermiquement isolant de sorte que seule une face supérieure 184 de cette piste affleure à l'intérieur de la cavité 174. Cette piste 176 est raccordée à un potentiel de référence tel que la masse. Elle s'étend horizontalement entre une extrémité gauche plus proche du plot 16 que du plot 17 et une extrémité droite plus proche du plot 17 que du plot 16. La couche 182 et le fluide thermiquement isolant emprisonné dans la cavité 174 forme un bloc en matériau thermiquement isolant à l'intérieur duquel est complètement enfouie la piste 176.

Les interrupteurs thermiques 178 et 179 sont placés, respectivement, entre cette extrémité gauche et le plot 16 et entre cette extrémité droite et le plot 17. Les interrupteurs 178 et 179 sont identiques et seul l'interrupteur 178 va maintenant être décrit plus détail.

L'interrupteur 178 comprend une lame flexible 186 et une électrode 188.

La lame 186 s'étend entre une extrémité fixe 190 et une extrémité libre 192.

L'extrémité 190 est fixée sans aucun degré de liberté à proximité du plot 16. En particulier, cette extrémité 190 est plus proche du plot 16 et, de préférence, au moins deux ou trois fois plus proche du plot 16 que de la face supérieure 184 de la piste 176. Ici, cette extrémité 190 est séparée du plot 16 uniquement par une fine couche du fluide thermiquement isolant et par le toit du capot 172. Ainsi, la partie du toit du capot 172 en vis-à-vis de l'extrémité 190 forme un plot d'extrémité du pont thermique 175.

La lame 186 est déplaçable entre :
- une position ouverte dans laquelle l'extrémité 192 est séparée de la piste 176 par une épaisseur e de fluide thermiquement isolant au moins deux et, de préférence, au moins dix ou cinquante fois supérieure à l'épaisseur du fluide thermiquement isolant qui sépare l'extrémité 190 du toit du capot 172, et
- une position fermée dans laquelle cette extrémité libre est directement en contact mécanique avec la face supérieure 184 de la piste 176.

Sur la figure 18, la position ouverte a été représentée en trait plein tandis que la position fermée a été représentée en pointillé.

Dans la position ouverte, la lame 186 s'étend horizontalement tandis que dans la position fermée, la lame 186 est courbée vers le bas. La lame 186 est réalisée dans un matériau thermiquement conducteur.

Les positions des extrémités 190 et 192 sont choisies de manière à ce que la valeur de la conductivité thermique de l'interrupteur 178 soit égale à λᵣ dans la position ouverte et égale à λ_{c} dans la position fermée. Comme précédemment, le rapport λ_{c}/λᵣ est supérieur à 2 ou 2,5 et, de préférence, supérieur à 5 ou 10.

Dans ces conditions, la position ouverte correspond à l'état résistif de l'interrupteur tandis que la position fermée correspond à l'état conducteur.

L'électrode 188 est un pion vertical. L'extrémité supérieure de l'électrode 188 est fixée sans aucun degré de liberté à l'extrémité 190 de la lame 186. L'extrémité inférieure de l'électrode 188 est ancrée dans la couche 182.

L'électrode 188 est réalisée dans un matériau électriquement conducteur. Elle est électriquement raccordée au module 10 par une liaison électrique non représentée. Elle est également thermiquement isolée de la piste 176 par la couche 182.

Quand le module 10 applique une différence de potentiels entre l'électrode 188 et la piste 176, la lame 186 se courbe et se déplace de sa position ouverte vers sa position fermée. Lorsque la lame 186 est dans sa position fermée, celle-ci est conformée de manière à ce qu'elle reste collée à la piste 176 même en absence de la différence de potentiels initialement utilisée pour la déplacer vers cette position fermée. Dans ces conditions, pour revenir dans l'état résistif, le module 10 applique une différence de potentiels de signe opposé pour ramener la lame 186 de sa position fermée vers sa position ouverte. Le reste du fonctionnement de la plaque 170 est similaire à celui de la plaque 32. Ainsi, il n'est pas nécessaire que les interrupteurs thermiques soient réalisés à partir de matériau à conductivité variable.

Le dispositif électronique peut fonctionner sans boucle d'asservissement gérée par le module 10 de commande. Dans ce cas, aucune estimation ni mesure de la température n'est indispensable ou une estimation simplifiée de la température est utilisée. Par exemple, le dispositif est géré par le module 10 en fonction de l'état de marche ou d'arrêt des modules électroniques formant les points chauffants. Le pont thermique relie une source de chaleur vers un point froid, dès que les modules électroniques leur correspondant sont mis en marche et en arrêt respectivement. Dès que les deux sont mis en marche ou en arrêt simultanément, la commande 10 ferme simultanément les interrupteurs thermiques du pont thermique les reliant. Si uniquement l'un des modules électroniques est mis en marche, pendant que l'autre est en arrêt, alors le module 10 ouvre simultanément les interrupteurs thermiques du pont thermique les reliant.

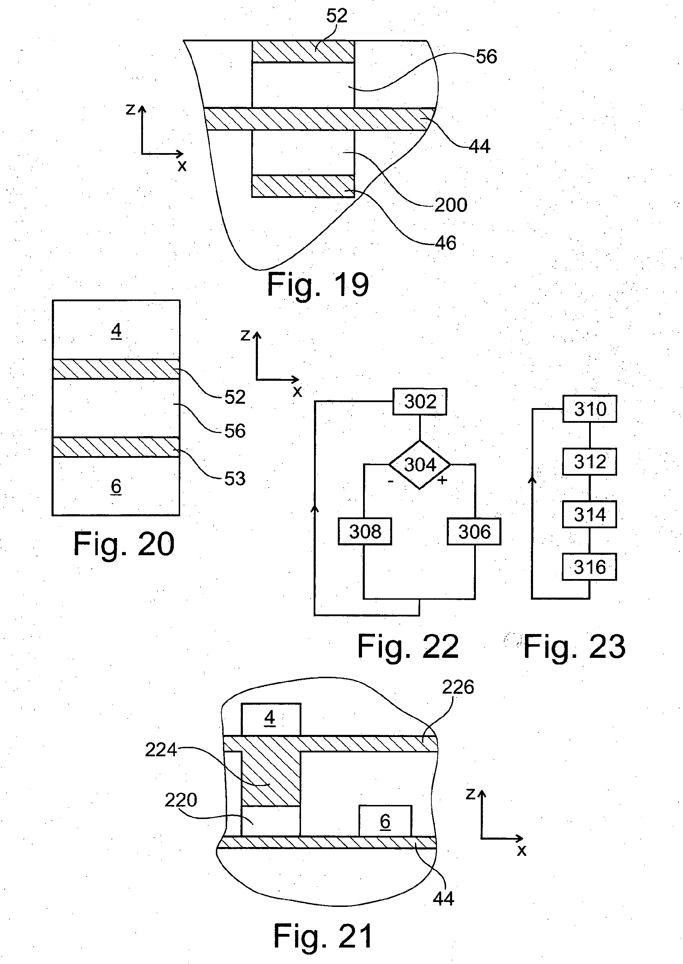

Ce principe est illustré par le procédé de la figure 22 dans le cas particulier des modules 4 et 6.

Lors d'une étape 302, le module 10 détecte si les modules électroniques 4, 6 sont en mode dissipatif de chaleur. Un module électronique est dit en mode dissipatif de chaleur lorsque sa densité de chaleur est supérieure à une valeur seuil Q₁. La valeur Q₁ est généralement supérieure à 1 W/cm², mais elle peut être inférieure à 1 W/cm² ou 0.5 W/cm² ou 0.1 W/cm² si l'application qui utilise les modules électroniques est sensible à la chaleur.

Lors d'une étape 304, le module 10 vérifie si les deux modules électroniques 4 et 6 sont simultanément en mode dissipatif de la chaleur.

Dans le cas où les deux modules électroniques sont simultanément en mode dissipatif de chaleur, ou tous les deux simultanément non dissipatifs de chaleur, alors, lors d'une étape 306, le module 10 fait basculer les deux interrupteurs thermiques 56 et 57 dans l'état résistif.

Dans le cas où uniquement et exactement l'un des deux modules est en mode dissipatif de chaleur, alors, lors d'une étape 308, le module 10 fait automatiquement basculer les deux interrupteurs thermiques 56, 57 dans l'état conducteur.

Les étapes 302 à 308 sont réitérées en boucle de manière améliorer la répartition des flux de chaleur à l'intérieur du dispositif 2.

Dans une autre réalisation, le dispositif peut fonctionner sans boucle d'asservissement gérée par le module 10 et sans estimation ni mesure de la température de la source de chaleur ou du point froid. Par exemple, le module 10 gère les interrupteurs thermiques du pont thermique d'une manière périodique, avec une période de plusieurs secondes en général, ou de quelques microseconde, et dans certains cas quelques nanosecondes. Dans ce cas, l'ouverture et la fermeture des interrupteurs thermiques sert à homogénéiser la température des dispositifs électroniques à une température entre celle de la source de chaleur et celle du point froid, dont la valeur dépend de la périodicité du basculement des états des interrupteurs thermiques. La vitesse à laquelle la température du dispositif électronique s'uniformise dépend aussi de la périodicité du basculement des interrupteurs thermiques.

Ce principe est illustré par le procédé de la figure 23 dans le cas particulier des modules 4 et 6. Lors d'une étape 310, le module 10 bascule les deux interrupteurs thermiques 56, 57 du pont thermique dans l'état conducteur.

Ensuite, durant une étape 312, le module 10 attend un temps prédéterminé, plusieurs secondes en général, ou quelques microseconde, et dans certains cas quelques nanosecondes.

Lors d'une étape 314, le module 10 bascule les deux interrupteurs thermiques 56, 57 du pont thermique dans l'état résistif.

Durant une étape 316, le module 10 attend un temps prédéterminé, qui peut être différent de celui de l'étape 312.

Les étapes 310 à 316 sont ainsi réitérées en boucle pour homogénéiser la température du dispositif 2 à une température entre celle de la source de chaleur et celle du point froid, et dont la valeur dépend de la périodicité du basculement des états des interrupteurs thermiques.

De nombreux autres modes de réalisation sont possibles. Par exemple, d'autres modes de réalisation de la grille 40 sont possibles. Par exemple, les pistes qui s'étendent parallèlement à la direction X ne sont pas nécessairement thermiquement raccordées en permanence aux pistes qui s'étendent parallèlement à la direction Y. Par exemple, dans ce cas, les pistes parallèles à la direction X s'étendent dans un plan situé en dessus du plan dans lequel s'étendent les pistes parallèles à la direction Y. La figure 19 représente un exemple d'intersection des pistes 44 et 46 dans ce cas là. Un interrupteur thermique 200 est interposé entre les pistes 46 et 44. Cet interrupteur 200 permet de raccorder thermiquement les pistes 44 et 46 et, en alternance, d'isoler thermiquement les pistes 44 et 46. Par exemple, cette interrupteur 200 est réalisé comme l'un des interrupteurs thermiques précédemment décrit. Ceci permet de mieux diriger et de façon plus sélective le flux de chaleur entre une source de chaleur et un point froid.

Dans un autre mode de réalisation, la grille 40 peut être omise. Dans ce cas, comme représenté sur la figure 20, les plots d'extrémité 52 et 53 sont par exemple directement raccordés thermiquement à une électrode respective de l'interrupteur thermique 56. Dans ce mode de réalisation, de préférence, les modules électroniques 4 et 6 sont superposés l'un au-dessus de l'autre dans la direction verticale.

La grille 40 ne s'étend pas nécessairement que dans un seul plan horizontal. Par exemple, la grille 40 peut aussi comporter des pistes s'étendant dans différents plans horizontaux disposés les uns au-dessus des autres dans la direction verticale. Dans ce cas, comme représenté sur la figure 21, les pistes s'étendant dans des plans parallèles différents sont de préférence raccordées thermiquement les unes aux autres par l'intermédiaire d'un interrupteur thermique 220 et d'un via 224 en matériau thermiquement conducteur. Sur la figure 21, la référence 226 désigne une piste s'étendant dans un plan horizontal parallèlement au plan de la piste 44. Dans cette variante, la grille forme une matrice à trois dimensions et des modules électroniques peuvent être disposés entre les différents plans de la grille.

En variante, sur la figure 21, l'interrupteur thermique 220 est omis. Dans ce cas, les pistes s'étendant dans différents plans parallèles sont thermiquement raccordées en permanence par l'intermédiaire de vias thermiques verticaux.

Les directions dans lesquelles s'étendent les différentes pistes de la grille ne sont pas nécessairement perpendiculairement les unes autres.

Il est également possible que toutes les pistes de la grille s'étendent dans une seule et même direction.

Il n'est pas indispensable que toutes les pistes de la grille aient la même longueur. En effet, leur longueur peut suivre le placement des modules électroniques.

Le matériau utilisé pour la grille 40 peut être du tungstène au lieu du cuivre, si le température lors de la suite du procédé de fabrication est élevée, par exemple plus de 350°C ou 400°C.

Les pistes thermiquement conductrices n'étendent pas nécessairement uniquement parallèlement au plan du substrat. Par exemple, en variante, la piste conductrice s'étend aussi perpendiculairement au plan de ce substrat pour être directement raccordée à d'autres pistes thermiquement conductrices situées dans des plans supérieurs ou inférieurs parallèles.

En variante, plusieurs épaisseurs de matériaux à conductivité thermique variable sont empilés les uns au-dessus des autres, par exemple dans la direction verticale, pour augmenter le ratio des valeurs λ_{c}/λᵣ.

Les différents interrupteurs thermiques d'un même pont thermique ne sont pas nécessairement tous identiques. Ainsi, dans une même plaque et dans un même pont thermique, les différents types d'interrupteurs thermiques précédemment décrits peuvent être mélangés.

Dans un autre mode de réalisation, les positions de l'électrode soluble et de l'électrode inerte sont inversées.

D'autre matériau thermiquement isolant peuvent être utilisé. Par exemple un matériau de conductivité thermique moyenne qui peut devenir thermiquement isolant selon sa géométrie et son épaisseur, est le silicium.

Les ponts thermiques peuvent être intégrés directement à l'intérieur du circuit intégré et non pas rapportés par collage d'une plaque sur une face de ce circuit intégré.

Le dispositif électronique ou la plaque peut comporter plusieurs ponts thermiques isolés thermiquement en permanence les uns des autres.

Dans d'autres configurations, la source chaude comprend d'autres composants électroniques dissipant la chaleur que des transistors. Par exemple, ces composants électroniques peuvent être des résistance ou des circuits oscillants contenant des inductances et des capacités. Elle ne comprend pas nécessairement des transistors.

Le point froid n'est pas nécessairement un module électronique inactif. Il peut aussi s'agir d'autres éléments capables d'absorber de la chaleur. Par exemple, un point froid peut être un boîtier à l'intérieur duquel est logé le circuit intégré ou un radiateur apte à diffuser de la chaleur dans l'air ambiant ou autre. Le point froid peut aussi être un canal traversant le circuit intégré et à l'intérieur duquel circule un fluide caloporteur.

En variante, le module 10 de commande est intégré à l'intérieur de la plaque et non pas à l'intérieur du circuit intégré. De façon similaire, le réseau de capteurs peut être intégré à l'intérieur de la plaque plutôt que dans le circuit intégré.

Dans une autre variante, le réseau de capteurs est remplacé par un estimateur de températures des modules électroniques. Par exemple, cet estimateur estime la température ou la quantité de chaleur produite par un module électronique donné en fonction du débit d'informations transmis à ce module électronique. Typiquement, un tel estimateur est implanté à l'intérieur du module 10 de commande.

Dans un autre mode de réalisation, le module de commande est électriquement raccordé à la grille 40 pour faire varier sa tension. Dans ce mode de réalisation, les plots 16 et 17 sont électriquement isolés du module 10 et raccordés à un potentiel de référence.

En variante, l'électrode 188 se prolonge en dehors de la cavité 174 et en particulier au-delà du capot 172 pour former une piste thermiquement conductrice. Cette piste thermiquement conductrice est alors raccordée à une source de chaleur ou à un point froid. Dans ce mode de réalisation, les modules électroniques n'ont alors pas besoin d'être disposés et fixés sur le toit du capot 172 mais peuvent être séparés de ce capot 172 par un matériau thermiquement isolant.

Dans une autre variante, la lame 186 est suffisamment flexible pour revenir de sa position fermée vers sa position ouverte dès qu'aucune différence de potentiels n'est appliquée entre l'électrode 188 et la piste 176. Ainsi, dans ce mode de réalisation, pour maintenir l'interrupteur thermique dans l'état conducteur, il faut appliquer en permanence la différence de potentiels. Par contre, il n'est pas nécessaire d'appliquer une différence de potentiels de signe opposé pour ramener la lame vers sa position ouverte.

La lame 186 peut être déplacée entre ses positions ouverte et fermée par d'autres actionneurs. Par exemple, la piste 176 et la lame 186 sont réalisées dans un matériau magnétique et c'est un champ magnétique qui est utilisé pour déplacer la lame 186 entre ses deux positions ouverte et fermée.

Le circuit intégré n'est pas nécessairement un circuit intégré 3D. Il peut aussi s'agir d'un circuit intégré 2D dans lequel tous les composants électroniques sont répartis dans un même plan. Dans une variante, le circuit intégré intègre des MEMS (Microelectromechanical systems) ou des NEMS(Nanoelectromechanical systems). Ces MEMS ou NEMS comportent au moins une partie mécanique qui se déplace ou se déforme en réponse à un apport d'énergie. Le déplacement ou cette déformation peuvent produire de la chaleur. Ainsi, ces MEMS peuvent constituer une source de chaleur qui peut être refroidie à l'aide d'une des plaques précédemment décrites. Par exemple, la partie mécanique qui se déplace est une poutre ou une membrane suspendue.

## Revendications

1. Dispositif électronique comportant :
- au moins une source (4) de chaleur générant de la chaleur,
- au moins un point froid (6) apte à absorber de la chaleur,
- un matériau thermiquement isolant (7) dont la conductivité thermique à la température d'utilisation T_{f} du dispositif est inférieure à un seuil S₁, ce matériau isolant thermiquement la source de chaleur du point froid,
- au moins un pont thermique (38) s'étendant entre au moins une première et une seconde extrémités (52, 53) raccordées thermiquement, respectivement, à la source de chaleur et au point froid,
**caractérisé en ce que** :
- les deux extrémités du pont thermique sont raccordées, respectivement, au point froid et à la source de chaleur par des plots d'extrémité,
- le pont thermique comprend entre ses deux plots d'extrémité, au moins un interrupteur thermique (56, 57 ; 97, 98 ; 130, 131) apte à basculer de façon réversible entre:
- un état conducteur dans lequel sa conductivité thermique à la température d'utilisation T_{f} prend une valeur λ_{c} supérieure au seuil S₁ pour raccorder thermiquement les deux plots d'extrémité du pont thermique, et -
- un état résistif dans lequel sa conductivité thermique à la température d'utilisation T_{f} prend une valeur λᵣ inférieure à la valeur λ_{c} pour isoler thermiquement les deux plots d'extrémité du pont thermique, et l'interrupteur thermique (56, 57 ; 97, 98 ; 130, 131) comprenant à cet effet un matériau à conductivité thermique variable (60 ; 100, 102 ; 138) apte à basculer en réponse à un apport d'énergie entre :
- une phase conductrice dans laquelle la conductivité thermique du matériau à la température d'utilisation T_{f} prend la valeur λ_{c} pour raccorder thermiquement les deux plots d'extrémité du pont thermique lorsque l'interrupteur thermique est dans l'état conducteur, et
- une phase résistive dans laquelle la conductivité thermique du matériau à la température d'utilisation T_{f} prend la valeur λᵣ pour isoler thermiquement les deux plots d'extrémité du pont thermique lorsque l'interrupteur thermique est dans l'état résistif.
- le dispositif électronique comprend un module (10) de commande apte à faire basculer l'interrupteur thermique entre ses états conducteur et résistif.

2. Dispositif selon la revendication 1, dans lequel le module (10) de commande est apte à faire basculer automatiquement l'interrupteur thermique entre ses états conducteur et résistif indépendamment d'une mesure ou d'une estimation de la température de la source de chaleur ou du point froid.

3. Dispositif selon la revendication 1, dans lequel le module (10) de commande est apte à faire basculer automatiquement l'interrupteur thermique entre ses états conducteur et résistif en fonction d'une mesure ou d'une estimation de la température de la source de chaleur ou du point froid.

4. Dispositif selon la revendication 3, dans lequel le dispositif comprend également au moins un capteur (12, 13) ou un estimateur apte à établir la mesure ou l'estimation d'une grandeur physique représentative de la température de la source de chaleur ou du point froid.

5. Dispositif selon l'une quelconque des revendications précédentes, dans lequel la valeur λᵣ est inférieure ou égale à la conductivité thermique du matériau thermiquement isolant à la température d'utilisation T_{f}.

6. Dispositif selon l'une quelconque des revendications précédentes, dans lequel :
- le dispositif comporte un bloc (34) s'étendant essentiellement dans un plan, dit « plan du substrat », et présentant une face de contact en contact thermique avec la source de chaleur et le point froid, ce bloc étant réalisée dans le premier matériau dont la conductivité thermique à une température d'utilisation T_{f} de la plaque est inférieure à un seuil S₁,
- les première et seconde extrémités (52, 53) du pont thermique sont définies sur la face de contact, et
- le dispositif comporte au moins une piste (44-47 ; 176) en matériau thermiquement conducteur pour raccorder thermiquement les première et seconde extrémités, cette piste étant enfouie à l'intérieur du bloc (34) de manière à être séparée de la face de contact par le premier matériau, le matériau thermiquement conducteur ayant une conductivité thermique à la température d'utilisation T_{f} supérieure au seuil S₁.

7. Dispositif selon l'une quelconque des revendications précédentes, dans lequel le matériau à conductivité thermique variable est un électrolyte solide (60 ; 138) ou un mélange :
- d'un fluide (100) thermiquement isolant dont la valeur de la conductivité thermique à la température d'utilisation T_{f} est inférieure ou égale au seuil S₁, et
- de nanoparticules (102) dont la valeur de la conductivité thermique est supérieure ou égale à λ_{c} à la température d'utilisation T_{f}, ces nanoparticules ayant la propriété de s'aligner sur des lignes de champs électrique en présence d'un champ électrique.

8. Dispositif selon la revendication 7, dans lequel l'électrolyte solide (60 ; 138) comprend des sulfites de métaux, des chalcogénides à base de germanium, des oxydes, du ZnCdS ou du GdOₓ/Cu-Te.

9. Dispositif selon l'une quelconque des revendications précédentes, dans lequel :
- le dispositif comporte plusieurs exemplaires dudit pont thermique s'étendant entre des première et seconde extrémités respectives,
- la source de chaleur ou le point froid est apte à se déplacer, à l'intérieur du dispositif, d'une extrémité d'un premier de ces ponts thermiques vers l'extrémité distincte d'un second de ces ponts thermiques, et
- le module de commande, en réponse au déplacement de la source de chaleur ou du point froid, est apte :
• à identifier quel pont thermique relie actuellement la source de chaleur au point froid, et
• à commander le basculement de l'interrupteur du pont thermique identifié de l'état résistif vers l'état conducteur, et
• à commander le basculement des interrupteurs des ponts thermiques qui ne relient pas une source de chaleur à un point froid de l'état conducteur vers l'état résistif.

10. Dispositif selon l'une quelconque des revendications précédentes, dans lequel le rapport de la valeur λ_{c} sur la valeur λᵣ est au moins supérieur ou égal à deux et, de préférence, supérieur ou égal à cinq.

11. Plaque pour diriger la chaleur au sein d'un dispositif électronique, cette plaque comportant :
- un bloc (34) s'étendant essentiellement dans un plan, dit « plan du substrat », et présentant une face de contact destinée à venir en contact thermique avec au moins une source de chaleur et au moins un point froid, ce bloc étant réalisée dans un premier matériau dont la conductivité thermique à une température d'utilisation T_{f} de la plaque est inférieure à un seuil S₁, et
- au moins un pont thermique (38) comportant :
• une première et une seconde extrémités définies sur la face de contact, et
• au moins une piste (44-47 ; 176) en matériau thermiquement conducteur pour raccorder thermiquement les première et seconde extrémités, cette piste étant enfouie à l'intérieur du bloc de manière à être séparée de la face de contact par le premier matériau, le matériau thermiquement conducteur ayant une conductivité thermique à la température d'utilisation T_{f} supérieure au seuil S₁,
**caractérisée en ce que** les deux extrémités du pont thermique sont raccordées au point froid et à la source de chaleur par des plots d'extrémité et **en ce que** le pont thermique comprend, entre au moins l'un des deux plots d'extrémité (52, 53) et la piste, au moins un interrupteur thermique (56, 57 ; 97, 98 ; 130, 131 ; 178, 179) apte à basculer de façon réversible entre :
- un état conducteur dans lequel sa conductivité thermique à la température d'utilisation T_{f} prend une valeur λ_{c} supérieure au seuil S₁ pour raccorder thermiquement les deux plots d'extrémité du pont thermique, et
- un état résistif dans lequel sa conductivité thermique à la température d'utilisation T_{f} prend une valeur λᵣ inférieure à la valeur λ_{c} pour isoler thermiquement les deux plots d'extrémité du pont thermique.

12. Plaque selon la revendication 11, dans laquelle :
- la piste (44-47 ; 176) s'étend entre une première partie (48, 49) à proximité du premier plot d'extrémité et une seconde partie à proximité du second plot d'extrémité,
- un premier exemplaire de l'interrupteur thermique est placé entre le premier plot d'extrémité et la première partie de la piste, et
- un second exemplaire de l'interrupteur thermique est placé entre le second plot d'extrémité et la seconde partie de la piste.

13. Plaque selon la revendication 12, dans laquelle la plaque comprend :
- plusieurs pistes (44, 46) thermiquement conductrices formant une grille, au moins une première piste de cette grille chevauchant une seconde piste de cette grille de sorte que ces première et seconde pistes sont en vis-à-vis l'une de l'autre dans une zone de chevauchement, et
- un troisième exemplaire (200) de l'interrupteur thermique interposé entre les première et seconde pistes dans la zone de chevauchement pour raccorder thermiquement ces deux pistes, et en alternance, isoler thermiquement ces deux pistes en réponse à une commande de basculement.

## Patentansprüche

1. Elektronische Vorrichtung, die Folgendes umfasst:
- wenigstens eine Wärmequelle (4), die Wärme erzeugt,
- wenigstens einen kalten Punkt (6), der Wärme absorbieren kann,
- ein wärmeisolierendes Material (7), dessen spezifische Wärmeleitfähigkeit bei der Verwendungstemperatur T_{f} der Vorrichtung kleiner als ein Schwellenwert S₁ ist, wobei dieses Material die Wärmequelle von dem kalten Punkt thermisch isoliert,
- wenigstens eine Wärmebrücke (38), die sich zwischen wenigstens einem ersten und einem zweiten Ende (52, 53), die mit der Wärmequelle bzw. dem kalten Punkt thermisch verbunden sind, erstreckt,
**dadurch gekennzeichnet, dass**:
- die beiden Enden der Wärmebrücke mit dem kalten Punkt bzw. der Wärmequelle durch Endkontakte verbunden sind,
- die Wärmebrücke zwischen ihren zwei Endkontakten wenigstens einen thermischen Unterbrecher (56, 57; 97, 98; 130, 131) umfasst, der reversibel kippen kann zwischen:
- einem leitenden Zustand, in dem seine spezifische Wärmeleitfähigkeit bei der Verwendungstemperatur T_{f} einen Wert λ_{c} größer als der Schwellenwert S₁ annimmt, um die beiden Endkontakte der Wärmebrücke thermisch zu verbinden, und
- einem resistiven Zustand, in dem seine spezifische Wärmeleitfähigkeit bei der Verwendungstemperatur T_{f} einen Wert λᵣ annimmt, der kleiner als der Wert λ_{c} ist, um die beiden Endkontakte der Wärmebrücke thermisch zu isolieren, und
der thermische Unterbrecher (56, 57; 97, 98; 130, 131) hierzu ein Material mit veränderlicher spezifischer Wärmeleitfähigkeit (60; 100, 102; 138) enthält, das in Reaktion auf einen Energieeintrag kippen kann zwischen:
- einer leitenden Phase, in der die spezifische Wärmeleitfähigkeit des Materials bei der Verwendungstemperatur T_{f} den Wert λ_{c} annimmt, um die beiden Endkontakte der Wärmebrücke thermisch zu verbinden, wenn der thermische Unterbrecher im leitenden Zustand ist, und
- einer resistiven Phase, in der die spezifische Wärmeleitfähigkeit des Materials bei der Verwendungstemperatur T_{f} den Wert λᵣ annimmt, um die beiden Endkontakte der Wärmebrücke thermisch zu isolieren, wenn der thermische Unterbrecher im resistiven Zustand ist,
- wobei die elektronische Vorrichtung ein Steuermodul (10) umfasst, das den thermischen Unterbrecher zwischen seinem leitenden und seinem resistiven Zustand kippen lassen kann.

2. Vorrichtung nach Anspruch 1, wobei das Steuermodul (10) den thermischen Unterbrecher unabhängig von einer Messung oder einer Schätzung der Temperatur der Wärmequelle oder des kalten Punkts zwischen seinem leitenden Zustand und seinem resistiven Zustand automatisch kippen lassen kann.

3. Vorrichtung nach Anspruch 1, wobei das Steuermodul (10) den thermischen Unterbrecher als Funktion einer Messung oder einer Schätzung der Temperatur der Wärmequelle oder des kalten Punkts zwischen seinem leitenden Zustand und seinem resistiven Zustand automatisch kippen lassen kann.

4. Vorrichtung nach Anspruch 3, wobei die Vorrichtung außerdem wenigstens einen Sensor (12, 13) oder eine Schätzeinrichtung umfasst, der bzw. die die Messung oder die Schätzung einer physikalischen Größe bilden kann, die die Temperatur der Wärmequelle oder des kalten Punkts repräsentiert.

5. Vorrichtung nach einem der vorhergehenden Ansprüche, wobei der Wert λᵣ kleiner oder gleich der spezifischen Wärmeleitfähigkeit des wärmeisolierenden Materials bei der Verwendungstemperatur T_{f} ist.

6. Vorrichtung nach einem der vorhergehenden Ansprüche, wobei:
- die Vorrichtung einen Block (34) umfasst, der sich im Wesentlichen in einer Ebene, der so genannten "Substratebene", erstreckt und eine Kontaktfläche für thermischen Kontakt mit der Wärmequelle und dem kalten Punkt aufweist, wobei dieser Block aus einem ersten Material hergestellt ist, dessen spezifische Wärmeleitfähigkeit bei der Verwendungstemperatur T_{f} der Platte kleiner als ein Schwellenwert S₁ ist,
- das erste und das zweite Ende (52, 53) der Wärmebrücke auf der Kontaktfläche definiert sind und
- die Vorrichtung wenigstens eine Bahn (44-47; 176) aus wärmeleitendem Material umfasst, um das erste und das zweite Ende thermisch zu verbinden, wobei diese Bahn in dem Block (34) vergraben ist, derart, dass sie von der Kontaktfläche durch das erste Material getrennt ist, wobei das wärmeleitende Material eine spezifische Wärmeleitfähigkeit bei der Verwendungstemperatur T_{f} besitzt, die größer als der Schwellenwert S₁ ist.

7. Vorrichtung nach einem der vorhergehenden Ansprüche, wobei das Material mit veränderlicher spezifischer Wärmeleitfähigkeit ein Festkörperelektrolyt (60; 138) oder ein Gemisch ist aus:
- einem wärmeisolierenden Fluid (100), dessen Wert der spezifischen Wärmeleitfähigkeit bei der Verwendungstemperatur T_{f} kleiner oder gleich einem Schwellenwert S₁ ist, und
- Nanopartikeln (102), deren Wert der spezifischen Wärmeleitfähigkeit bei der Verwendungstemperatur T_{f} größer oder gleich λ_{c} ist, wobei diese Nanopartikel die Eigenschaft haben, sich in Gegenwart eines elektrischen Feldes auf die elektrischen Feldlinien auszurichten.

8. Vorrichtung nach Anspruch 7, wobei der Festkörperelektrolyt (60; 138) Metallsulfite, Chalcogenite auf Germaniumbasis, Oxide von ZnCdS oder von GdOₓ/Cu-Te umfasst.

9. Vorrichtung nach einem der vorhergehenden Ansprüche, wobei:
- die Vorrichtung mehrere Exemplare der Wärmebrücke umfasst, die sich zwischen jeweiligen ersten und zweiten Enden erstrecken,
- die Wärmequelle oder der kalte Punkt dafür ausgelegt ist, sich innerhalb der Vorrichtung von einem Ende einer ersten dieser Wärmebrücken zu dem anderen Ende einer zweiten dieser Wärmebrücken zu verlagern, und
- das Steuermodul in Reaktion auf die Verlagerung der Wärmequelle oder des kalten Punkts dafür ausgelegt ist:
• zu identifizieren, welche Wärmebrücke derzeit die Wärmequelle mit dem kalten Punkt verbindet, und
• das Kippen des Unterbrechers der identifizierten Wärmebrücke von dem resistiven Zustand in den leitenden Zustand zu befehlen, und
• das Kippen der Unterbrecher der Wärmebrücken, die nicht eine Wärmequelle mit einem kalten Punkt verbinden, von dem leitenden Zustand in den resistiven Zustand zu befehlen.

10. Vorrichtung nach einem der vorhergehenden Ansprüche, wobei das Verhältnis des Wertes λ_{c} zu dem Wert λᵣ wenigstens größer oder gleich zwei und vorzugsweise größer oder gleich fünf ist.

11. Platte, um Wärme in einer elektronischen Vorrichtung zu lenken, wobei diese Platte Folgendes umfasst:
- einen Block (34), der sich im Wesentlichen in einer Ebene, der so genannten "Substratebene" erstreckt und eine Kontaktfläche aufweist, die mit wenigstens einer Wärmequelle und wenigstens einem kalten Punkt in thermischen Kontakt gelangen soll, wobei dieser Block aus einem ersten Material verwirklicht ist, dessen spezifische Wärmeleitfähigkeit bei einer Verwendungstemperatur T_{f} der Platte kleiner als ein Schwellenwert S₁ ist, und
- wenigstens eine Wärmebrücke (38), die Folgendes umfasst:
- ein erstes und ein zweites Ende, die auf der Kontaktfläche definiert sind, und
- wenigstens eine Bahn (44-47; 176) aus einem wärmeleitenden Material, um das erste und das zweite Ende thermisch zu verbinden, wobei diese Bahn innerhalb des Blocks vergraben ist, derart, dass sie von der Kontaktfläche durch das erste Material getrennt ist, wobei das wärmeleitende Material eine spezifische Wärmeleitfähigkeit bei der Verwendungstemperatur T_{f} besitzt, die größer als der Schwellenwert S₁ ist,
**dadurch gekennzeichnet, dass** die zwei Enden der Wärmebrücke mit dem kalten Punkt und mit der Wärmequelle durch Endkontakte verbunden sind und dass die Wärmebrücke zwischen wenigstens einem der zwei Endkontakte (52, 53) und der Bahn wenigstens einen thermischen Unterbrecher (56, 57; 97, 98; 130, 131; 178, 179) umfasst, der reversibel kippen kann zwischen:
- einem leitenden Zustand, in dem seine spezifische Wärmeleitfähigkeit bei der Verwendungstemperatur T_{f} einen Wert λ_{c} größer als der Schwellenwert S₁ annimmt, um die beiden Endkontakte der Wärmebrücke thermisch zu verbinden, und
- einem resistiven Zustand, in dem seine spezifische Wärmeleitfähigkeit bei der Verwendungstemperatur T_{f} einen Wert λᵣ kleiner als der Wert λ_{c} annimmt, um die beiden Endkontakte der Wärmebrücke thermisch zu isolieren.

12. Platte nach Anspruch 11, wobei:
- die Bahn (44-47; 176) sich zwischen einem ersten Teil (48, 49) in der Nähe des ersten Endkontakts und einem zweiten Teil in der Nähe des zweiten Endkontakts erstreckt,
- ein erstes Exemplar des thermischen Unterbrechers zwischen dem ersten Endkontakt und dem ersten Teil der Bahn angeordnet ist und
- ein zweites Exemplar des thermischen Unterbrechers zwischen dem zweiten Endkontakt und dem zweiten Teil der Bahn angeordnet ist.

13. Platte nach Anspruch 12, wobei die Platte Folgendes umfasst:
- mehrere wärmeleitende Bahnen (44, 46), die ein Gitter bilden, wobei wenigstens eine erste Bahn dieses Gitters mit einer zweiten Bahn dieses Gitters überlappt, derart, dass sich diese erste und diese zweite Bahn in einer Überlappungszone einander gegenüber befinden, und
- ein drittes Exemplar (200) des thermischen Unterbrechers, der zwischen die erste und die zweite Bahn in der Überlappungszone eingefügt ist, um in Reaktion auf einen Kippbefehl diese beiden Bahnen abwechselnd thermisch zu verbinden und thermisch zu isolieren.

## Claims

1. Electronic device comprising:
- at least one heat source (4) generating heat;
- at least one cold point (6) able to absorb heat;
- a thermally insulating material (7) the thermal conductivity of which at the temperature T_{f} of use of the device is below a threshold S₁, this material thermally insulating the heat source from the cold point; and
- at least one thermal bridge (38) extending between at least a first end (52) and a second end (53), these ends being thermally connected to the heat source and cold point, respectively;
**characterized in that**:
- the two ends of the thermal bridge are connected to the cold point and the heat source, respectively, by end pads; and
- the thermal bridge comprises, between its two end pads, at least one thermal switch (56, 57; 97, 98; 130, 131) able to switch reversibly between:
- a conductive state in which its thermal conductivity at the temperature T_{f} of use takes a value λ_{c} above the threshold S₁ in order to connect thermally the two end pads of the thermal bridge; and
- a resistive state in which its thermal conductivity at the temperature T_{f} of use takes a value λᵣ lower than the value λ_{c} in order to insulate thermally the two end pads of the thermal bridge,
the thermal switch (56, 57; 97, 98; 130, 131) comprising for this purpose a material (60; 100, 102; 138) of variable thermal conductivity able to switch, in response to a supply of energy, between:
- a conductive phase in which the thermal conductivity of the material at the temperature T_{f} of use takes the value λ_{c} in order to connect thermally the two end pads of the thermal bridge when the thermal switch is in the conductive state; and
- a resistive phase in which the thermal conductivity of the material at the temperature T_{f} of use takes the value λᵣ in order to insulate thermally the two end pads of the thermal bridge when the thermal switch is in the resistive state; and
- the electronic device comprises a control module (10) able to switch the thermal switch between its conductive and resistive states.

2. Device according to Claim 1, in which the control module (10) is able to make the thermal switch automatically switch between its conductive and resistive states, independently of a measurement or estimation of the temperature of the heat source or cold point.

3. Device according to Claim 1, in which the control module (10) is able to make the thermal switch automatically switch between its conductive and resistive states, depending on a measurement or estimation of the temperature of the heat source or cold point.

4. Device according to Claim 3, in which the device also comprises at least one sensor (12, 13) or an estimator able to measure or estimate a physical quantity representative of the temperature of the heat source or cold point.

5. Device according to any one of the preceding claims, in which the value λᵣ is lower than or equal to the thermal conductivity of the thermally insulating material at the temperature T_{f} of use.

6. Device according to any one of the preceding claims, in which:
- the device comprises a block (34) lying essentially in a plane, called the "plane of the substrate", and having a contact face making thermal contact with the heat source and the cold point, this block being made of the first material the thermal conductivity of which at a temperature T_{f} of use of the plate is below a threshold S₁;
- the first and second ends (52, 53) of the thermal bridge are defined on the contact face; and
- the device comprises at least one track (44-47; 176) made of a thermally conductive material in order to connect thermally the first and second ends, this track being embedded inside the block (34) so as to be separated from the contact face by the first material, the thermally conductive material having a thermal conductivity at the temperature T_{f} of use above the threshold S₁.

7. Device according to any one of the preceding claims, in which the material of variable thermal conductivity is a solid electrolyte (60; 138) or a mixture of:
- a thermally insulating fluid (100) the value of the thermal conductivity of which at the temperature T_{f} of use is lower than or equal to the threshold S₁; and
- nanoparticles (102) the value of the thermal conductivity of which is higher than or equal to λ_{c} at the temperature T_{f} of use, these nanoparticles having the property of aligning along electric field lines in the presence of an electric field.

8. Device according to Claim 7, in which the solid electrolyte (60; 138) comprises metal sulphites, chalcogenides based on germanium, oxides, ZnCdS or GdOₓ/Cu-Te.

9. Device according to any one of the preceding claims, in which:
- the device comprises a plurality of examples of said thermal bridge extending between respective first and second ends;
- the heat source or the cold point is able to move, inside the device, from one end of a first of these thermal bridges to the separate end of a second of these thermal bridges; and
- the control module, in response to the movement of the heat source or cold point, is able:
• to identify which thermal bridge currently connects the heat source to the cold point; and
• to switch the switch of the identified thermal bridge from the resistive state to the conductive state; and
• to switch the switches of the thermal bridges that do not connect a heat source to a cold point from the conductive state to the resistive state.

10. Device according to any one of the preceding claims, in which the ratio of the value λ_{c} to the value λᵣ is at least higher than or equal to two and preferably higher than or equal to five.

11. Plate for directing heat within an electronic device, this plate comprising:
- a block (34) lying essentially in a plane, called the "plane of the substrate", and having a contact face intended to make thermal contact with at least one heat source and at least one cold point, this block being made of a first material the thermal conductivity of which at a temperature T_{f} of use of the plate is below a threshold S₁; and
- at least one thermal bridge (38), comprising:
• a first end and a second end, these ends being defined on the contact face; and
• at least one track (44-47; 176) made of a thermally conductive material in order to connect thermally the first and second ends, this track being embedded inside the block so as to be separated from the contact face by the first material, the thermally conductive material having a thermal conductivity at the temperature T_{f} of use above the threshold S₁,
**characterized in that** the two ends of the thermal bridge are connected to the cold point and the heat source by end pads, and **in that** the thermal bridge comprises, between at least one of the two end pads (52, 53) and the track, at least one thermal switch (56, 57; 97, 98; 130, 131; 178, 179) able to switch reversibly between:
- a conductive state in which its thermal conductivity at the temperature T_{f} of use takes a value λ_{c} above the threshold S₁ in order to connect thermally the two end pads of the thermal bridge; and
- a resistive state in which its thermal conductivity at the temperature T_{f} of use takes a value λᵣ lower than the value λ_{c} in order to insulate thermally the two end pads of the thermal bridge.

12. Plate according to Claim 11, in which:
- the track (44-47; 176) extends between a first portion (48, 49) in proximity to the first end pad and a second portion in proximity to the second end pad;
- a first example of the thermal switch is placed between the first end pad and the first portion of the track; and
- a second example of the thermal switch is placed between the second end pad and the second portion of the track.

13. Plate according to Claim 12, in which the plate comprises:
- a plurality of thermally conductive tracks (44, 46) forming a grid, at least a first track of this grid overlapping a second track of this grid so that these first and second tracks face each other in a zone of overlap; and
- a third example (200) of the thermal switch, interposed between the first and second tracks in the zone of overlap in order, in alternation, to connect thermally these two tracks and to insulate thermally these two tracks in response to a switching command.
